# EUROPÄISCHE PATENTANMELDUNG

(11) **EP 1 316 999 A1**
(43) Veröffentlichungstag der Anmeldung: **04.06.2003**
(21) Anmeldenummer: 01128251.4
(22) Anmeldetag: 28.11.2001
(51) Int. Cl.: H01L 23/495, H01L 25/07

(54) **Verfahren und Vorichtung zum Kontaktieren von Leistungselektronik-Bauelementen**

(71) Anmelder: Continental ISAD Electronic Systems GmbH & Co. oHG, 86899 Landsberg/Lech (DE)
(72) Erfinder: Schmid, Ralf, 86899 Landsberg (DE); Schmidt, Marco, 86899 Landsberg (DE)
(74) Vertreter: Niederkofler, Oswald A., Dipl.-Phys.

(57) **Zusammenfassung**

Die Erfindung betrifft ein Verfahren zum Kontaktieren von einem oder mehreren Leistungselektronik-Bauelementen (10) mit Leiterbahnen (14, 15) auf einem Träger (12, 18) mithilfe einer Kontaktvorrichtung (1) mit mehreren flächigen durch Stege (4, 5) zusammenhängenden Kontaktelementen (6, 8), welches die folgenden Schritte umfaßt: (a) die Kontaktvorrichtung (1) wird auf die Oberseite des/der Bauelements/e (10) aufgesetzt; (b) die Unterseite eines Kontaktelements (6, 8) wird jeweils einerseits mit einer Kontaktfläche (S, G) auf der Oberseite eines Bauelements (10) und andererseits mit einer Leiterbahn (14, 15) elektrisch verbunden; (c) wenigstens einer der Stege (4, 5) zwischen den einzelnen Kontaktelementen (6, 8) wird durch thermisches Abtragen durchtrennt. Die Erfindung betrifft auch eine mit dem Verfahren hergestellte Baugruppe (16, 16'), sowie eine Kontaktvorrichtung (1) mit mehreren flächigen Kontaktelementen (6, 7) zum Kontaktieren von Leistungselektronik-Bauelementen (10).

## Beschreibung

Die Erfindung betrifft eine Kontaktvorrichtung und ein Verfahren zum Kontaktieren von Leistungselektronik-Bauelementen, sowie eine Baugruppe aus einem oder mehreren Leistungselektronik-Bauelementen, die mit Leiterbahnen auf einem Träger kontaktiert sind.

Für die Kontaktierung von integrierten elektronischen Bauelementen (Chips) sind im Stand der Technik die folgenden Kontaktierungsverfahren allgemein bekannt:

Beim sog. *Drahtbonden* wird ein Halbleiter-Bauelement auf ein Substrat aufgesetzt und die metallischen Kontaktflächen (Bondpads) der Bauelemente werden mit den Kontakten des Substrats durch feine Drähte aus Gold oder Aluminium verbunden, die z.B. durch Ultraschallschweißen an den Kontaktflächen befestigt werden. Wegen der seriellen Durchführung der Kontaktierungen ist das Drahtbonden relativ zeitaufwendig.

In der industriellen Fertigung von Mikroelektronikbauelementen wird daher auch die sog. *Tape-Automated-Bonding(TAB)-*Technik verwendet, bei welchem ein durch Ätzen auf einem Kunststoffträger (Tape) hergestellter Kupferkamm auf die Oberseite des Bauelements aufgelegt und mittels Thermokompression gleichzeitig mit allen Kontaktflächen des Bauelements verbunden wird.

Weiterhin ist die sog. *Flip-Chip-Technik* bekannt, bei welcher ein Chip direkt mit dem Substrat verbunden wird. Hierzu werden auf den Kontaktflächen auf der Unterseite des Bauelements sog. Löt-Bumps (Löthöcker) hergestellt, die bei Erwärmung des gesamten Substrats mit den Leiterbahnen des Substrats verbunden werden.

Diese bekannten Kontaktierungsverfahren sind jedoch z.B. aufgrund der kleinen Kontaktflächen nur bedingt für Leistungselektronik-Bauelemente geeignet, bei denen größerer Leistungen übertragen werden. Zwar werden Leistungselektronik-Bauelemente wie z.B. Leistungs-MOSFETs im allgemeinen durch Drahtbonden mit den Kontakten eines Substrats kontaktiert, hierbei werden jedoch für die Leistungskontakte (z.B. Source und Drain eines MOSFETs) aufgrund der hohen Ströme jeweils mehrere Drähte verwendet. Die Kontaktierung von Leistungselektronik-Bauelementen durch Drahtbonden ist daher relativ zeitaufwendig und kostenintensiv. Zudem können bei hohen Frequenzen Verzerrungen der Signale infolge der Induktivitäten der Bonddrähte auftreten.

In der Vergangenheit wurden Leistungselektronik-Bauelemente i.d.R. nicht ungekapselt auf ein Substrat aufgebracht, sondern mit einem Gehäuse versehen. Die DE-PS 19 11 633 offenbart zum Beispiel ein Verfahren zum Kontaktieren und Umhüllen von Halbleiter-Bauelementen, bei welchem das Bauelement auf einen gestanzten Zuleitungsrahmen montiert wird. Hierbei wird das Bauelement, z.B. ein Hochleistungstransistor, dessen Kontaktflächen mit Lot bedeckt sind, auf einen plattenartigen Teil des Zuleitungsrahmens aufgesetzt und die Enden von schmalen Zuleitungsstegen des Zuleitungsrahmens auf die Kontaktflächen auf der Oberseite des Transistors aufgesetzt. Der Rahmen mitsamt Bauelement wird nun in eine Preßform eingesetzt, die Temperatur bis zum Schmelzen des Lots erhöht und später die Preßform mit Plastikmaterial gefüllt. Zum Schluß werden Teile des aus dem umhüllten Bauelement herausstehenden Zuleitungsrahmens entfernt, um die Zuleitungen zu den einzelnen Kontakten elektrisch voneinander zu trennen.

Auch die US 4,809,054 zeigt ein Verfahren zum Kontaktieren von Halbleiterbauelementen mit einem Zuleitungsrahmen. Die auf der Ober- und Unterseite des Bauelements angeordneten Kontaktflächen werden mit Lot bedeckt, das Bauelement auf einen rechteckigen Abschnitt des Zuleitungsrahmens aufgesetzt und ein weiterer Abschnitt des Zuleitungsrahmens derart umgeklappt, daß er die Kontaktfläche auf der Oberseite des Bauelements kontaktiert.

Weiterhin sei noch die DE 199 33 975 A1 erwähnt, die ein Stanzgitter zur Kontaktierung der Anschlüsse einer Baugruppe aus mehreren elektronischen Bauteilen beschreibt.

Die Erfindung hat sich das Ziel gesetzt, ein kostengünstiges System zur Kontaktierung von Leistungselektronik-Bauelementen bereitzustellen, mit dem dennoch mechanisch und elektrisch stabile, insbesondere induktivitätsarme, Verbindungswege zu den Kontakten des Bauelements hergestellt werden können.

Die Erfindung erreicht dieses Ziel durch die Gegenstände der Ansprüche 1, 7 und 14. Vorteilhafte Ausführungsformen der Erfindungen sind u.a. in den jeweils abhängigen Ansprüchen angegeben.

Danach stellt die Erfindung ein Verfahren zum Kontaktieren von einem oder mehreren Leistungselektronik-Bauelementen mit Leiterbahnen auf einem Träger bereit. Das Verfahren wird mit Hilfe einer Kontaktvorrichtung mit mehreren flächigen durch Stege zusammenhängenden Kontaktelementen durchgeführt und umfaßt die folgenden Schritten: (a) Die Kontaktvorrichtung wird auf die Oberseite des/der Bauelements(e) aufgesetzt; (b) die Unterseite eines Kontaktelements wird jeweils einerseits mit einer Kontaktfläche auf der Oberseite eines Bauelements und andererseits mit einer Leiterbahn elektrisch verbunden; (c) wenigstens einer der Stege zwischen den einzelnen Kontaktelementen wird durch thermisches Abtragen durchtrennt.

Außerdem stellt die Erfindung eine Kontaktvorrichtung zum Kontaktieren eines oder mehrerer Leistungselektronik-Bauelemente mit Leiterbahnen auf einem Träger bereit. Die Kontaktvorrichtung umfaßt ein oder mehrere flächige Kontaktelemente, die jeweils zum Verbinden einer Kontaktfläche eines Bauelements mit einer Leiterbahn geeignet sind. Die einzelnen Kontaktelemente der Kontaktvorrichtung hängen über Stege zusammen, die durch Laser- Elektronen- und/oder lonenstrahlschneiden durchtrennbar sind.

Die Erfindung stellt schließlich eine Baugruppe bereit, welche ein oder mehrere Leistungselektronik-Bauelemente umfaßt, die wenigstens auf ihrer Oberseite Kontaktflächen aufweisen, sowie einen Träger mit Leiterbahnen, auf denen die Bauelemente mit ihrer Unterseite aufliegen. Außerdem umfaßt die Baugruppe ein oder mehrere flächige Kontaktelemente zum Kontaktieren das/der Bauelements(e) mit den Leiterbahnen, wobei ein Kontaktelement jeweils einerseits mit einer Kontaktfläche auf der Oberseite eines Bauelements und andererseits mit einer Leiterbahn elektrisch verbunden ist.

Die Erfindung wird nun anhand von bevorzugten Ausführungsbeispielen und der beigefügten Zeichnung näher erläutert. In der Zeichnung zeigen jeweils schematisch:
- Fig. 1: eine perspektivische Ansicht einer Kontaktvorrichtung gemäß einem ersten Ausführungsbeispiel;
- Fig. 2: eine perspektivische Ansicht eines zu kontaktierenden Leistungselektronik-Bauelements;
- Fig. 3: eine perspektivische Ansicht einer Baugruppe gemäß einem ersten Ausführungsbeispiel;
- Fig. 4: eine perspektivische Ansicht der Baugruppe der Fig. 3, mit durchtrennten Stegen;
- Fig. 5: eine perspektivische Ansicht einer Baugruppe gemäß einem zweiten Ausführungsbeispiel;
- Fig. 6: eine schematische Darstellung von mehreren in einem Kühlbehälter aufgehängten Baugruppen gemäß zweitem Ausführungsbeispiel;
- Fig. 7: eine perspektivische Ansicht einer Leiterbahn; und
- Fig. 8: eine perspektivische Ansicht einer Kontaktvorrichtung gemäß einem zweiten Ausführungsbeispiel;

In den Figuren sind funktionsgleiche oder -ähnliche Teile zum Teil mit gleichen Bezugszeichen gekennzeichnet.

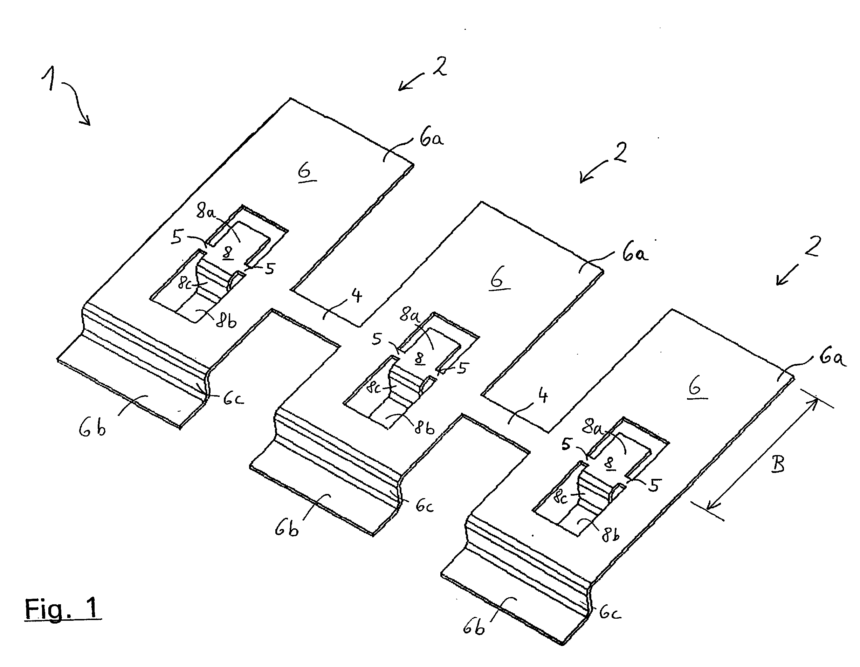

Fig. 1 zeigt ein Beispiel einer erfindungsgemäßen Kontaktvorrichtung. Bevor diese und die weiteren Figuren näher erläutert werden, folgen zunächst einige allgemeine Anmerkungen zu den bevorzugten Ausführungsbeispielen:

Unter "Leiterbahn" wird im folgenden der Kontaktbereich verstanden, der mit den metallischen Kontaktflächen (sog. Pads) eines Halbleiterbauelements (Chips) verbunden ist. Im allgemeinen sind dies flächige Metallbahnen auf einem Chipsträger, jedoch sind auch andere Ausführungsformen denkbar.

Durch die Flächigkeit der erfindungsgemäßen Kontaktelemente in den Ausführungsbeispielen ist die Induktivität der Verbindungswege zwischen Bauelement und Leiterbahnen gering, was insbesondere bei hochfrequenten Anwendungen vorteilhaft ist. Zudem bedingen die entsprechend großen Verbindungsflächen einen geringen Kontaktwiderstand und daher insbesondere bei hohen Strömen eine vergleichsweise geringere Erwärmung des Bauelements. Im Gegensatz beispielsweise zu der Drahtbond-Technik sind für die Kontaktierungen keine speziellen Kontaktoberflächen notwendig, da die elektrischen Verbindungen durch ein beliebiges einfaches Verfahren z.B. Löten oder Bonden hergestellt werden können.

In den Ausführungsbeispielen des erfindungsgemäßen Kontaktierungs-Verfahrens wird eine Kontaktvorrichtung aus mehreren flächigen Kontaktelementen verwendet, die während der Montage noch durch Stege zusammenhängen, so daß die Kontaktelemente zusammen auf das/die zu kontaktierenden Bauelement/e aufgesetzt werden können. Nach der Herstellung der elektrischen Verbindungen wird bevorzugt wenigstens einer der Stege durchtrennt, um die entsprechenden Kontaktelemente elektrisch voneinander zu trennen. Hierzu wird bevorzugt ein thermisches Abtragverfahren verwendet, was den Vorteil hat, daß es - im Gegensatz zu vielen mechanischen Trennverfahren wie z.B. Stanzen - nur von einer Seite Zugriff auf die Trennstelle benötigt. Unter dem Bauelement kann sich also ein fester Träger wie z.B. ein Substratplättchen befinden.

Bevorzugt wird ein berührloses thermisches Abtragverfahren verwendet, was den Vorteil hat, daß beim Durchtrennen des Steges keine mechanischen Kräfte übertragen werden und sich daher keine mechanischen Spannungen in der Kontaktvorrichtung oder dem Bauelement ausbilden können. Beispielsweise wird ein Laserstrahl auf die Kontaktvorrichtung fokussiert und der Träger mitsamt Bauelementen in die gewünschte Schneiderichtung des Lasers bewegt. Das Laserschneiden erlaubt die genaue Dosierung der in die Schnittstelle eingebrachten Energiemenge und die Erzeugung von exakt definierten Schnittkanten.

In den Ausführungsbeispielen weist wenigstens ein Bauelement auf seiner unteren Seite eine Kontaktfläche auf, die auf eine Leiterbahn aufgesetzt und mit dieser elektrisch verbunden wird. Die direkte Kontaktierung mit der Leiterbahn hat den Vorteil eines besonders kurzen Verbindungsweges und bietet sich insbesondere bei in Vertikaltechnik aufgebauten Bauelementen, wie z.B. vertikalen MOSFET-Leistungstransistoren an, bei denen entweder der Sourceoder Drainkontakt auf der Unterseite des Transistorchips angeordnet ist. Derartige Bauelemente müssen also von beiden Seiten kontaktiert werden.

Bei den bevorzugten Ausführungsbeispielen werden sämtliche elektrische Verbindungen, ggf. auch die o.g. Verbindung zwischen der Unterseite eines Bauelements und einer Leiterbahn, in einem Arbeitsgang hergestellt. Hierdurch ergeben sich gegenüber der seriellen Drahtbond-Technik erhebliche Kosteneinsparungen. Vorzugsweise werden die elektrischen Verbindungen durch ein sog. Reflow-Lötverfahren hergestellt. Hierbei wird das Lot, i.d.R. durch Lötpastendruck, z.B. Siebdruck, auf die Kontaktvorrichtung und ggf. die Leiterbahnen aufgebracht und daraufhin die Bauelemente auf die Leiterbahnen und die Kontaktvorrichtung auf die Bauelemente aufgesetzt, was durch die Hafteigenschaften der Lötpaste erleichtert wird. Die Lötpaste kann alternativ auch auf die Bauelemente selbst aufgebracht werden. Schließlich wird das Lot durch ein Simultan-Lötverfahren beispielsweise in einem Durchlaufofen oder durch Dampfphasenlöten zum Schmelzen gebracht. Beim Dampfphasenlöten wird die bestückte Baugruppe in eine Zone mit heißem, gesättigtem Dampf gebracht, wobei der auf der kälteren Baugruppe kondensierende Dampf die zur Lotaufschmelzung benötigte Wärmeenergie abgibt. Alternativ können auch Einzellötverfahren wie Stempel- oder Laserlöten, sowie beliebige andere Löt- und Bondverfahren eingesetzt werden.

Die Kontaktvorrichtung der bevorzugten Ausführungsbeispiele ist aus einem Stanzteil oder einem Stanzbiegeteil hergestellt. Als Ausgangsmaterial wird hierfür ein dünnes Kupferblech von z. B. ca. 100-500 µm Dicke verwendet und eine gitterartige Anordnung aus jeweils durch Stege zusammenhängenden Kontaktelementen ausgestanzt. Zur Anpassung an die Form der Bauelemente wird die Kontaktvorrichtung ggf. in einigen Bereichen gebogen.

Die Abschnitte der Kontaktelemente, die mit den Kontaktflächen des Bauelements kontaktiert werden sollen, sind an die Form und/oder Größe der entsprechenden Kontaktfläche angepaßt. Insbesondere decken die Kontaktelemente für die Leistungskontakte (z.B. Source oder Drain eines MOSFET's) die entsprechenden Leistungskontaktflächen der Bauelemente vollständig ab, damit über die gesamte Kontaktfläche eine elektrische Verbindung mit dem Kontaktelement hergestellt werden kann und somit der Kontaktwiderstand gering gehalten wird.

Die Kontaktelemente für die Steuerkontakte (z.B. das Gate eines MOSFET's) weisen bevorzugt einen kleineren Querschnitt auf als die Leistungskontakte, d.h. dem Strom zwischen Leiterbahn und Kontaktfläche steht ein kleinere Leiterquerschnitt zur Verfügung, und sind jeweils in einer Ausnehmung eines Kontaktelements für einen Leistungskontakt angeordnet. Diese Anordnung ist insbesondere für die Kontaktierung von Bauelementen vorteilhaft, bei denen der Steuerkontakt ebenfalls in einer Ausnehmung des Leistungskontakts angeordnet ist, wie z.B. bei gegenwärtigen Leistungs-MOSFET's. Zudem ergibt sich eine kompakte Anordnung aller Kontaktelemente für ein Bauelement.

Die Kontaktvorrichtung der bevorzugten Ausführungsbeispiele weist Positionierungshilfen zum Positionieren der Kontaktvorrichtung auf dem bzw. den Bauelementen und/oder dem Substrat auf. Dies erleichtert zunächst das Ausrichten der Kontaktvorrichtung bzgl. der Bauelemente und dem Substrat beim Aufsetzten und dient außerdem dazu, ein Verrutschen der Kontaktvorrichtung während des bevorzugt verwendeten simultanen Reflow-Lötprozesses zu verhindern. Werden nämlich sämtliche Verbindungsstellen gleichzeitig erhitzt, "schwimmen" die Kontaktvorrichtung und die Bauelemente praktisch auf dem flüssigen Lot der Kontaktflächen und verrutschen daher leicht. Alternativ oder zusätzlich zu den Positionierhilfen ist bevorzugt ein Federmittel vorgesehen, welches die Kontaktvorrichtung gegen das bzw. die Bauelemente und/oder gegen das Substrat elastisch beaufschlagt und hierdurch ein Verrutschen verhindert.

Bei dem Träger der Bauelemente und Leitbahnen handelt es sich bei einem ersten Ausführungsbeispiel um ein Substratplättchen wie z.B. ein Epoxidharzoder Keramiksubstrat. Das Keramiksubstrat aus z.B. Al₂O₃ oder AIN ist mit einer 300-400 µm dicken Kupferschicht kaschiert, in die die Leiterbahnen durch ein photolitographisches Verfahren eingeätzt sind. Die Unterseite des Substrat ist ebenfalls mit Kupfer beschichtet, um eine unsymmetrische Ausdehnung der Substratschichten bei Erwärmung zu vermeiden. Keramik ist ein guter Isolator und sehr temperaturstabil, hat aber einen großen thermischen Widerstand und trägt daher kaum zur Abführung der Verlustwärme der Bauelemente bei. Bei einem zweiten Ausführungsbeispiel wird daher als Träger ein Kunststoffrahmen verwendet, der um die Leiterbahnen gespritzt ist. Die Leiterbahnen sind also praktisch frei aufgehängt und daher gur zu kühlen. Bei den besonders bevorzugten Ausführungsbeispielen ist der Kunststoffrahmen in einem Behälter mit Kühlflüssigkeit aufgehängt.

Die fertige Baugruppe wird beispielsweise als Halbbrücke oder als Wechselrichter bevorzugt für einen Drehstrommotor verwendet. Insbesondere für die Verwendung bei Kurbelwellen-Starter-Generatoren weist die Baugruppe der Ausführungsbeispiele große Vorteile auf, da die flächigen elektrischen Verbindungen große mechanische Stabilität aufweisen und daher der im Kraftfahrzeug auftretenden Rüttelbelastung standhalten. Vorzugsweise sind sowohl Leistungs-Bauelemente wie Leistungs-MOSFETs/-Dioden, als auch Logik-Bauelemente zur Ansteuerung der Leistungselektronik auf einem gemeinsamen Träger und somit in einer Baugruppe angeordnet.

Nun zurückkommend auf die Figuren, zeigt Fig. 1 eine perspektivische Ansicht einer Kontaktvorrichtung 1 zur Kontaktierung 1 von drei Bauelementen mit jeweils zwei Kontaktflächen auf der Oberseite, z.B. drei vertikalen MOSFETs mit Source- und Gate-Kontakten auf der Oberseite. Mit Ziffer 2 ist jeweils eine Anordnung aus zwei Kontaktelementen 6, 8 zum Kontaktieren eines Bauelements gekennzeichnet. Die flächigen Kontaktelemente 6, 8 weisen jeweils Abschnitte 6a bzw. 8a zur Verbindung mit den Kontaktflächen des Bauelements und Abschnitte 6b bzw. 8b zur Verbindung mit den Leiterbahnen auf. In der fertigen Baugruppe sind die Bauelemente unter den Abschnitten 6a, 8a im Bereich B angeordnet, die Leiterbahnen unter den Abschnitten 6b, 8b; ggf. wird das Lot für die Herstellung der elektrischen Verbindungen also vor der Montage auf die (nicht gezeigte) Unterseite dieser Abschnitte aufgebracht. Die Abschnitte 6a, 8a und 6b, 6c verlaufen jeweils parallel zueinander und zu den Leiterbahnen, in den dazwischen liegenden Bereichen 6c, 8c sind die Kontaktelemente 6 bzw. 8 stufenartig abgebogen, um den Höhenunterschied zwischen den Leiterbahnen und der Oberseite des Bauelements zu überbrücken. In einigen (nicht gezeigten) Ausführungsbeispielen sind die Stufen S- oder Z-förmig gebogen, so daß die Bereiche 6c, 8c federnd wirken. Diese Federwirkung wird dazu genutzt, das Kontaktelement 1 während des Reflow-Lötprozesses z.B. durch eine Lötschablone auf die Leiterbahnen anzudrücken und somit einem Verrutschen der Kontaktvorrichtung 1 und der Bauelemente gegenüber den Leiterbahnen entgegenzuwirken.

Die Kontaktelemente 6, 8 hängen jeweils über dünne Stege 5 zusammen, die nach dem Kontaktieren der Bauelemente durch eines der o.g. thermischen Abtragverfahren durchtrennt werden, um die Zuleitungen 6, 8 elektrisch voneinander zu isolieren. Die breiteren Stege 4 zwischen den Kontaktelemente 6 können ebenfalls nach dem Kontaktieren der Bauelemente durchtrennt werden. Dies ist jedoch nicht notwendig, falls die drei Bauelemente, die durch die gezeigte Kontaktvorrichtung 1 kontaktiert werden, parallel geschaltet sind.

Da durch das Kontaktelement 8, welches die Gate-Elektrode kontaktiert, nur ein geringer Steuerstrom fließt, während durch das Kontaktelement 6 der von dem Leistungs-Bauelement geschaltete Strom von z.B. 10-25 Ampere fließt, ist das Kontaktelement 8 schmaler als das Kontaktelement 6 und weist daher eine geringere Querschnittsfläche auf. Auch der Verbindungsbereich 8a ist kleiner als der des Kontaktelements 6. Das Kontaktelement 8 befindet sich zudem in einer zentralen Ausnehmung des Kontaktelements 6, so daß alle Kontaktelemente für ein Bauelement kompakt angeordnet sind. In anderen (nicht gezeigten) Ausführungsbeispielen ist die Ausnehmung am Rand des Kontaktelements 6 angeordnet.

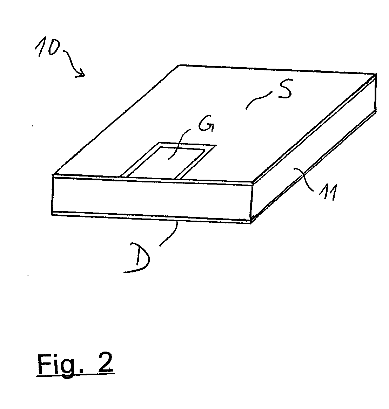

Fig. 2 zeigt ein durch die Kontaktvorrichtung 1 kontaktiertes Bauelement 10. Als Beispiel wurde hier ein Leistungs-MOSFET in einem Halbleiterkörper 11 gewählt, auf den metallische Kontaktflächen für die Gate-(G), Source-(S), und Drain-(D)Anschlüsse aufgebracht sind. Bei dem gezeigten Beispiel handelt es sich um einen vertikalen MOSFET, so daß die Drain-Kontaktfläche D auf der Unterseite und die Gate- und Source-Kontaktflächen G, S auf der Oberseite des Transistorplättchens angeordnet sind. Die Gate-Kontaktfläche ist erheblich kleiner als die Source-Kontaktfläche und in einer Ausnehmung derselben angeordnet. Aus einem Vergleich mit Fig. 1 wird deutlich, daß die Abschnitte 6a, 8a der dort gezeigten Kontaktelemente 6, 8 in Form und Fläche ungefähr den metallischen Source- bzw. Gate-Kontaktflächen S, G des Transistors 10 entsprechen.

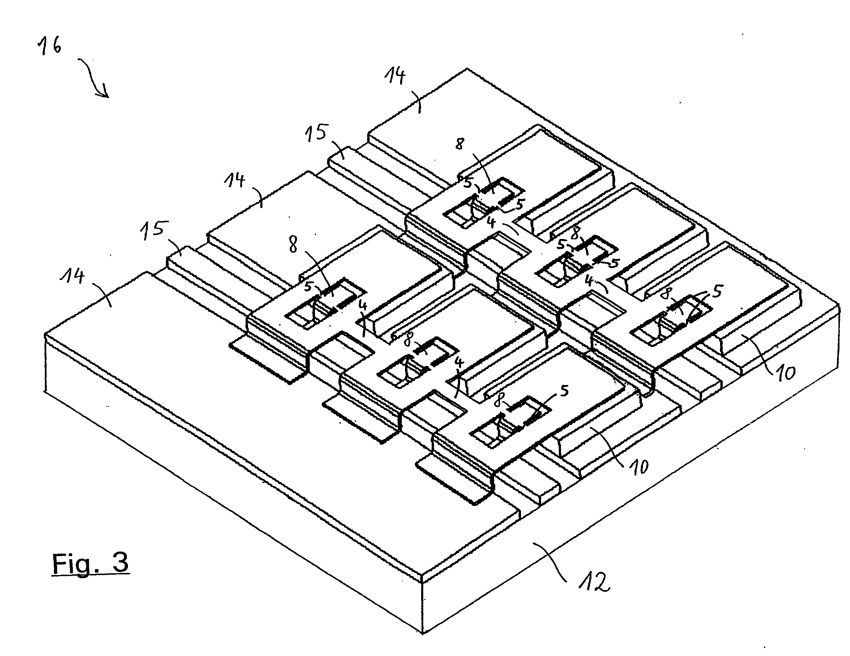

Fig. 3 zeigt eine Anordnung 16 von sechs derartigen Bauelementen 10 und zwei Kontaktvorrichtungen 1 der Fig. 1 auf einem Substratplättchen 12. Das Substratplättchen 12 besteht beispielsweise aus mit Kupfer beschichteter Keramik. Die breiteren Leiterbahnen 14 dienen der Kontaktierung der Leistungskonstakte, während die schmaleren Leiterbahnen 15 die Steuersignale führen.

Die Bauelemente 10 liegen mit ihrer Unterseite jeweils auf einer Leiterbahn 14, so daß der Drain-Anschluß D direkt z.B. durch Reflow-Löten mit dieser Leiterbahn kontaktiert werden kann.

Fig. 3 zeigt die Baugruppe 16 nach dem Aufsetzen der Kontaktvorrichtungen 1, jedoch vor dem Durchtrennen der Stege 5 bzw. 4. Ob die elektrischen Verbindungen bereits hergestellt sind, ist der Baugruppe 16 nicht anzusehen, da die Verbindungsstellen jeweils unter den Abschnitten 6a, 8a und 6b, 8b der Kontaktelemente 6, 8 liegen. Typischerweise wird vor dem Zusammensetzen der in Fig. 3 gezeigten Anordnung die Unterseite der Kontaktvorrichtung 1 durch Siebdruck mit Lotpaste bedruckt und nach dem Zusammensetzen die Verbindungsstellen gleichzeitig erhitzt und dadurch das Lot zum Schmelzen gebracht. Aufgrund der großen Flächen der Abschnitte 6a, 8a, 8b, 6b sind, wenn diese Abschnitte in ihrer ganzen Fläche mit Lot bedeckt werden, auch die späteren Verbindungsstellen relativ großflächig und weisen daher einen geringen Kontaktwiderstand und große mechanische Stabilität auf. Die große Breite, insbesondere der Leistungs-Kontaktelemente 6, führt zu einer geringen Induktivität der Leiterverbindungen und damit zu einem guten Signalverhalten bei hohen Frequenzen.

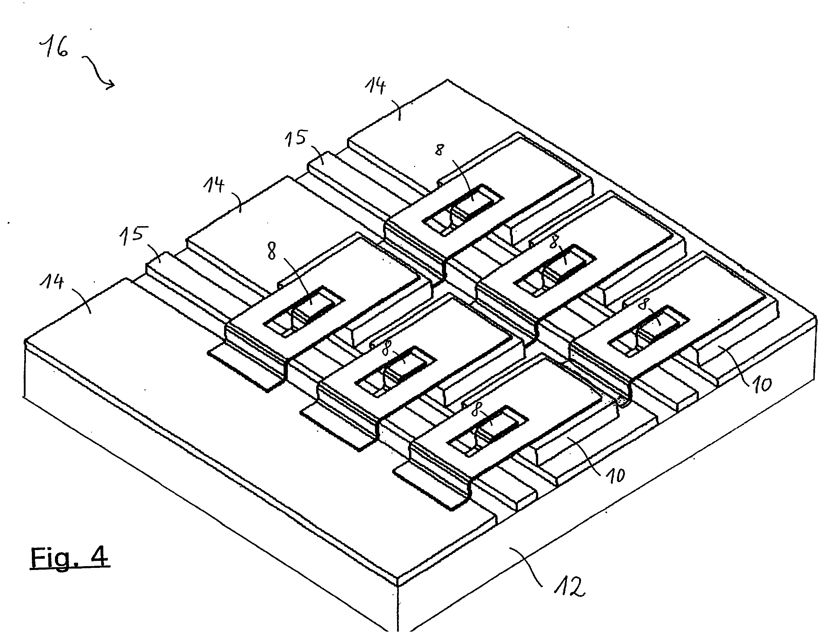

Nach dem Herstellen der elektrischen Verbindungen werden die Stege 4, 5, die für den mechanischen Zusammenhalt der Kontaktvorrichtung 1 nun nicht mehr benötigt werden und die Kontaktelemente 6, 8 kurz schalten, durch Laserschneiden durchtrennt oder herausgeschnitten. Schließlich wird die Baugruppe 16 zum Schutz ggf. mit einem Gel oder mit Epoxidharz überzogen. Fig. 4 zeigt die fertige Baugruppe 16 mit durchtrennten Stegen 4, 5. In anderen (nicht gezeigten) Ausführungsbeispielen werden auf die Oberseite der Kontaktvorrichtung 1 noch weitere Bauelemente 10 aufgesetzt und kontaktiert.

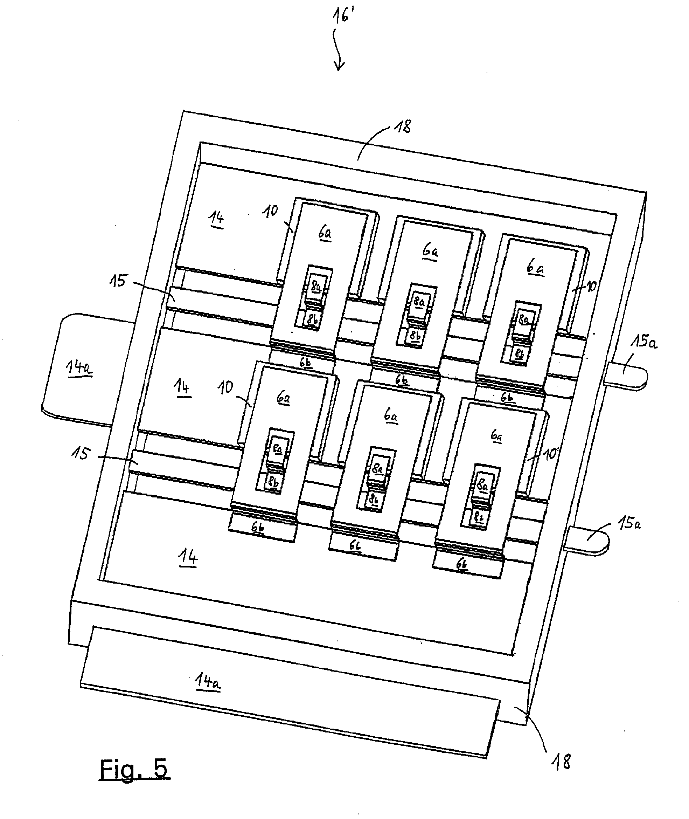

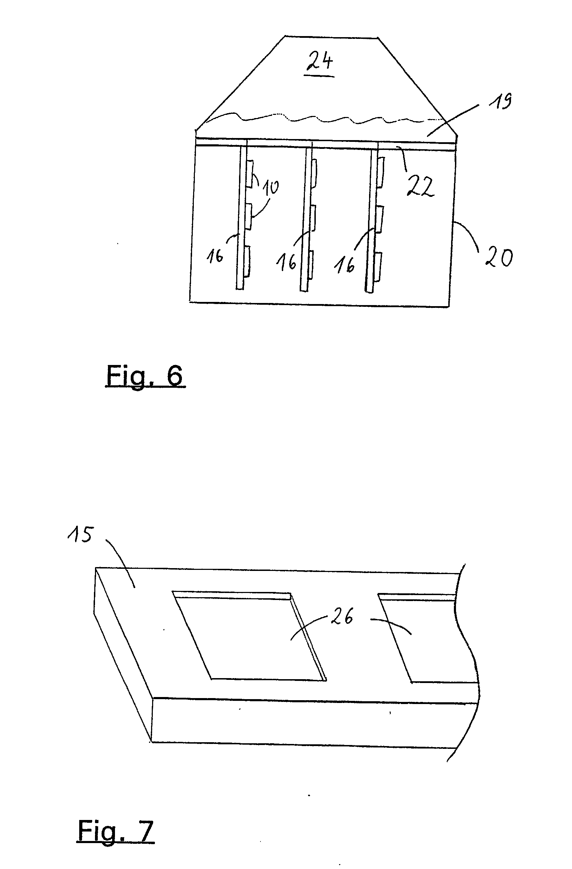

In Fig. 5 ist ein anderes Ausführungsbeispiel 16' der Baugruppe 16 dargestellt, bei der anstatt eines Keramiksubstrats 12 als Träger ein Kunststoffrahmen 18 verwendet wird. Dieser ist als Spritzteil ausgestaltet, in das die Leiterbahnen 14, 15 an ihren Enden eingelassen sind, wobei ein Ende jeder Leiterbahn 14, 15 als Anschlußstift 14a, 15a seitlich aus dem Kunststoffrahmen 18 herausragt. Die Leiterbahnen sind in diesem Beispiel ca. 1-3mm dick. Im Bereich der Bauelemente 10 sind die Leiterbahnen 14, 15 nämlich frei aufgehängt, so daß die Bauelemente 10 durch Luftkühlung oder mit einer Kühlflüssigkeit gekühlt werden können. Hierzu werden die fertigen Baugruppen 16' in dem in Fig. 6 gezeigten Ausführungsbeispiel in einem mit Kühlflüssigkeit 19 gefüllten druckdichten Behälter 20 an einer Halterung 22 aufgehängt und die Anschlußstifte 14a, 15a mit entsprechenden Anschlüssen in der Halterung 22 kontaktiert. Die Leiterbahnen und Bauelemente 10 sind von allen Seiten von der Kühlflüssigkeit 19 umgeben und können daher die Verlustleistung gut an diese abgeben. Die Kühlflüssigkeit 19 verdampft hierdurch teilweise und kondensiert in einem oberen Bereich 24 des Behälters 20.

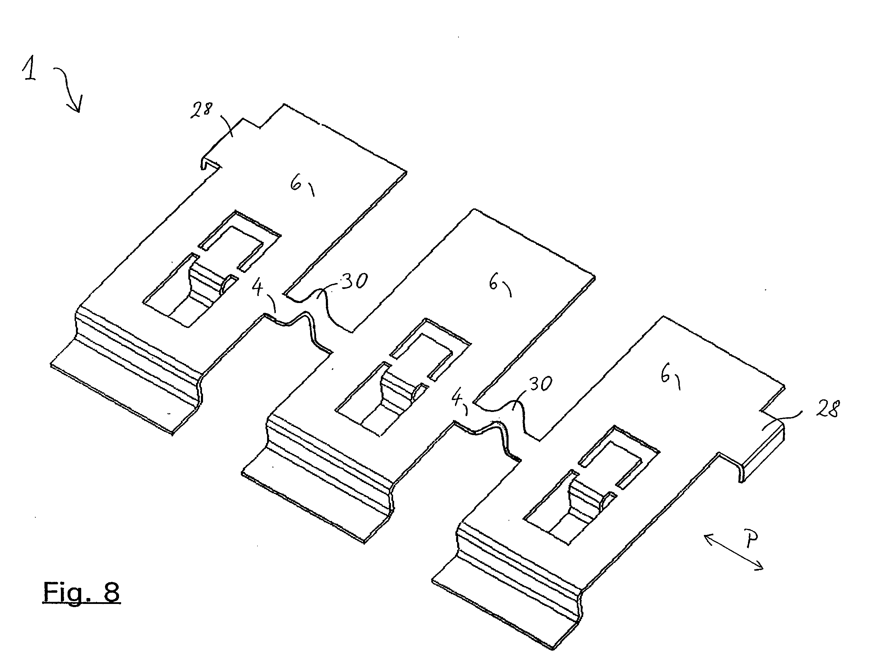

In den Figuren 7 und 8 sind die Positionierungsmittel dargestellt, mit denen ein Verrutschen der Bauelemente 10 und der Kontaktvorrichtung 1, insbesondere während des Verlötens der Verbindungsstellen 6a, 6b, 8a, 8b, verhindert wird. Fig. 7 zeigt hierzu eine Nahansicht einer Leiterbahn 15 einer Baugruppe 16'. An die Stelle, an der ein Bauelement aufgesetzt und ggf. mit der Leiterbahn kontaktiert werden soll, ist in die Leiterbahn 15 eine Wanne 26 eingeprägt, in die das Bauelement 10 genau hineinpaßt und die ein seitliches Verrutschen desselben verhindert. Auf eine Leiterbahn 15 auf einem Keramiksubstrat 12 wird eine derartige Wanne nicht durch Prägen erzeugt, sondern durch Aufdruck eines Lackrahmens, der die Grundfläche des Bauelements 10 ausspart und somit das in Fig. 7 gezeigte Oberflächenprofil erzeugt.

Fig. 8 zeigt eine Ausführungsform der Kontaktvorrichtung 1 mit Positionierungshilfen 28, mit denen die Kontaktvorrichtung 1 beim Aufsetzen auf die Bauelemente 10 in Bezug auf diese ausgerichtet wird. Die Positionierungshilfen 28 bestehen hier aus L-förmigen Fortsätzen der Kontaktvorrichtung 1, welche ein Bauelement 10 umgreifen. In dem gezeigten Beispiel verhindern die Positionierhilfen 28 das Verrutschen der Kontaktvorrichung in Richtung des Pfeils P; durch entsprechende Positionierhilfen 28 an den Stirnseiten der Kontaktelemente 6 (nicht gezeigt) kann auch in der hierzu senkrechten Richtung eine Positionierung erreicht werden. Durch Kombination der in Fig. 7 und 8 gezeigten Mittel wird also eine Fixierung sowohl der Kontaktvorrichtung 1 gegenüber den Bauelementen 10, als auch der Bauelemente 10 gegenüber den Leiterbahnen 14 erreicht.

Bei der Kontaktvorrichtung 1 der Fig. 8 sind außerdem die Stege 4 mit sog. "Entlastungsbögen" 30 ausgestattet, welche die Funktion haben, eventuell zwischen den einzelnen Kontaktelementen 6 auftretende mechanische Spannungen zu reduzieren. Dies gilt für den Fall, daß die Stege 4 nach dem Verlöten nicht durchtrennt werden, da die kontaktierten Bauelemente 10 parallel geschaltet sind.

## Patentansprüche

1. Kontaktvorrichtung (1) zum Kontaktieren eines oder mehrerer Leistungselektronik-Bauelemente (10) mit Leiterbahnen (14, 15) auf einem Träger (12, 18), wobei die Kontaktvorrichtung (1) ein oder mehrere flächige Kontaktelemente (6, 8) umfaßt, die jeweils zum elektrischen Verbinden einer Kontaktfläche (G, S) auf einem Bauelement (10) mit einer Leiterbahn (14, 15) ausgelegt sind, und wobei die einzelnen Kontaktelemente (6, 8) der Kontaktvorrichtung (1) über Stege (4, 5) zusammenhängen, die durch Laser-, Elektronenund/oder lonenstrahlschneiden durchtrennbar sind.

2. Kontaktvorrichtung (1) nach Anspruch 1, welche aus einem Stanzteil oder einem Stanzbiegeteil hergestellt ist.

3. Kontaktvorrichtung (1) nach Anspruch 1 oder 2, wobei wenigstens bei einem Kontaktelement (6, 8) die Form und/oder Größe des Kontaktelements (6, 8) an die Form und/oder Größe der zu kontaktierenden Kontaktfläche (G, S) angepaßt ist.

4. Kontaktvorrichtung (1) nach einem der vorstehenden Ansprüche, welche zum Kontaktieren von wenigstens einem Bauelement (10) mit sowohl Steuer- als auch Leistungskontakten geeignet ist, wobei ein Kontaktelement (8) für einen Steuerkontakt eine kleinere Querschnittsfläche aufweist als ein Kontaktelement für einen Leistungskontakt (6).

5. Kontaktvorrichtung (1) nach Anspruch 4, wobei wenigstens ein Kontaktelement (8) für einen Steuerkontakt in einer Ausnehmung eines Kontaktelements (6) für einen Leistungskontakt angeordnet ist und über wenigstens einen Steg (5) mit diesem zusammenhängt.

6. Kontaktvorrichtung (1) nach einem der vorstehenden Ansprüche, welche eine Positionierungshilfe (28) zum Positionieren der Kontaktvorrichtung (1) auf dem/den Bauelement(en) (10) und/oder dem Träger (12, 18) aufweist.

7. Baugruppe (16, 16') , welche umfaßt:
- ein oder mehrere Leistungselektronik-Bauelement(e) (10), die wenigstens auf ihrer Oberseite Kontaktflächen (G, S) aufweisen;
- einen Träger (12, 18) mit Leiterbahnen (14, 15), auf denen das/die Bauelement(e) (10) mit ihrer Unterseite aufliegt(en);
- ein oder mehrere flächige Kontaktelemente (6, 8) zum Kontaktieren des/der Bauelements(e) (10) mit den Leiterbahnen (14, 15), wobei ein Kontaktelement (6, 8) jeweils einerseits mit einer Kontaktfläche (S, G) auf der Oberseite eines Bauelements (10) und andererseits mit einer Leiterbahn (14, 15) des Trägers (12,18) elektrisch verbunden ist.

8. Baugruppe (16, 16') nach Anspruch 7, wobei die Kontaktelemente (6, 8) nach einem der Ansprüche 3-6 ausgestaltet sind.

9. Baugruppe (16, 16') nach einem der Ansprüche 7 oder 8, welche ein Logik-Bauelement umfaßt, mit dem die Leistungselektronik-Bauelemente (10) ansteuerbar sind.

10. Baugruppe (16, 16') nach einem der Ansprüche 7-9, welche die Funktion einer Halbbrücke oder eines Wechselrichters für einen Drehstrommotor erfüllt.

11. Baugruppe (16) nach einem der Ansprüche 7-10, wobei der Träger ein Substratplättchen (12) und insbesondere ein Keramiksubstrat ist.

12. Baugruppe (16') nach einem der Ansprüche 7-10, wobei der Träger ein Kunststoffrahmen (18) ist.

13. Baugruppe (16') nach Anspruch 12, die zur Kühlung der Bauelemente (10) in einem Behälter (20) mit Kühlflüssigkeit (19) angeordnet ist.

14. Verfahren zum Kontaktieren von einem oder mehreren Leistungselektronik-Bauelementen (10) mit Leiterbahnen (14, 15) auf einem Träger (12, 18) mithilfe einer Kontaktvorrichtung (1) mit mehreren flächigen durch Stege (4, 5) zusammenhängenden Kontaktelementen (6, 8), welches die folgenden Schritte umfaßt:
a) die Kontaktvorrichtung (1) wird auf die Oberseite des/der Bauelements/e (10) aufgesetzt;
b) die Unterseite eines Kontaktelements (6, 8) wird jeweils einerseits mit einer Kontaktfläche (S, G) auf der Oberseite eines Bauelements (10) und andererseits mit einer Leiterbahn (14, 15) des Trägers (12, 18) elektrisch verbunden;
c) wenigstens einer der Stege (4, 5) zwischen den einzelnen Kontaktelementen (6, 8) wird durch thermisches Abtragen durchtrennt.

15. Verfahren nach Anspruch 14, wobei in Schritt c) ein berührloses thermisches Abtragverfahren wie Laser-, Elektronen- oder lonenstrahlschneiden verwendet wird.

16. Verfahren nach einem der Ansprüche 14 oder 15, wobei wenigstens ein Bauelement (10) auf seiner Unterseite eine Kontaktfläche (D) aufweist, die auf einer Leiterbahn (14) aufliegt und vor oder in Schritt b) mit dieser elektrisch verbunden wird.

17. Verfahren nach einem der Ansprüche 14-16, wobei alle elektrischen Verbindungen in Schritt b) in einem Arbeitsgang hergestellt werden.

18. Verfahren nach Anspruch 17, wobei zum Herstellen der elektrischen Verbindungen ein Reflow-Lötverfahren verwendet wird.

19. Verfahren nach einem der Ansprüche 14-18, wobei die Kontaktvorrichtung (1) und/oder die Leiterbahnen (14) Positionierungshilfen aufweisen, die einem Verrutschen der Kontaktvorrichtung (1) und/oder des/der Bauelement(s)e (10) , insbesondere in Schritt b), entgegenwirken.

20. Verfahren nach einem der Ansprüche 14-19, wobei die Kontaktvorrichtung (1) nach einem der Ansprüche 1-6 ausgestaltet ist.

21. Verfahren nach einem der Ansprüche 14-20 zum Herstellen einer Baugruppe (16, 16') nach einem der Ansprüche 7-13.
